## Europäisches Patentamt
## European Patent Office
## Office européen des brevets

(19)

(11) Veröffentlichungsnummer: **0 000 715**
**B1**

(12)
# EUROPÄISCHE PATENTSCHRIFT

(45) Veröffentlichungstag der Patentschrift: **02.09.81**

(51) Int. Cl.³: **H 01 L 31/18, H 01 L 31/06**

(21) Anmeldenummer: **78100452.8**

(22) Anmeldetag: **20.07.78**

(54) Verfahren zur Herstellung von Cadmiumsulfid-Kupfersulfid-Solarzellen und nach diesem Verfahren hergestellte Solarzellen.

(30) Priorität: **21.07.77 DE 2732933**

(43) Veröffentlichungstag der Anmeldung:
**21.02.79 Patentblatt 79/4**

(45) Bekanntmachung des Hinweises auf die Patenterteilung:
**02.09.81 Patentblatt 81/35**

(84) Benannte Vertragsstaaten:
**BE CH FR GB NL**

(56) Entgegenhaltungen:
FR - A - 1 446 911
FR - A - 1 562 163
FR - A - 2 156 924
US - A - 3 472 690

THIN SOLID FILMS, vol. 45, no. 1, August 1977, Lausanne (CH)

G. H. HEWIG, W. H. BLOSS: "Technology of thin film solar cells", Seiten 1—7

Vorgelesen an der International Conference on Metallurgical Coatings, San Francisco USA, 28. Mäz — 1. April 1977.

(73) Patentinhaber: **Bloss, Werner H.,Prof. Dr.-Ing**
**Lindenstrasse 45**
**D-7065 Winterbach (DE)**

(72) Erfinder: **Bilger, Gerhard, Dipl.-Ing.**
**Rotebühlstrasse 111**
**D-7000 Stuttgart 1 (DE)**
Erfinder: **Hewig, Gert, Dr.-Ing.**
**Goldäckerstrasse 62**
**D-7031 Steinenbronn (DE)**
Erfinder: **Pfisterer, Fritz, Dipl.-Phys.**
**Charlottenstrasse 71**
**D-7128 Lauffen (DE)**
Erfinder: **Schock, Hans-Werner, Dipl.-Ing.**
**Dachsweg 5**
**D-7033 Herrenberg (DE)**

(74) Vertreter: **Wilhelm, Hans-Herbert, Dr.-Ing. et al,**
**Gymnasiumstrasse 31B**
**D-7000 Stuttgart 1 (DE)**

Courier Press, Leamington Spa, England.

## Verfahren zur Herstellung von Cadmiumsulfid-Kupfersulfid-Solarzellen und nach diesem Verfahren hergestellte Solarzellen

Die Erfindung betrifft ein Verfahren zum Herstellen von Solarzellen mit p-n-Dünnschicht-Heteroübergang aus einer auf einem Träger aufgebrachten elektrisch leitenden Unterlage, einer darauf aufgedampften Cadmiumsulfid-Schicht und einer darauf chemisch erzeugten Kupfersulfid-Schicht, auf die ein elektrisch leitendes Gitter aufgelegt wird, das mit einem Deckglas, das auf der dem Gitter zugewandten Seite mit einem Heißsiegelkleber versehen wird, abgedeckt, heißversiegelt und verpreßt wird, wobei der Träger mit der Unterlage, mit der Cadmiumsulfid-Schicht und mit der Kupfersulfid-Schicht als ein vorgefertigter Bauteil hergestellt wird.

Cadmiumsulfid-Solarzellen haben gegenüber den bekannten Silicium-Einkristall-Solarzellen einen geringeren Wirkungsgrad, jedoch den erheblichen Vorteil, daß sie sich wesentlich preiswerter herstellen lassen. Es ist bekannt, ein Halbleiterfotoelement aus einem dünnen Silicium-Einkristall mit p- und n-leitenden Zonen herzustellen, das anschließend durch Umhüllen mit einem Gießharz o.dgl. verkapselt wird. Cadmiumsulfid-Solarzellen, die zu den sogenannten Dünnschichtsolarzellen gehören, besitzen eine polykristalline Halbleiterschicht, die auf eine elektrisch leitende Unterlage, meistens einen metallischen Träger aufgedampft ist, so daß ihre Herstellung wesentlich preiswerter ist.

Es ist bekannt (Zeitschrift: THIN SOLID FILMS, vol. 45, no. 1, August 1977, Lausanne), zum Herstellen von Solarzellen mit p-n-Dünnschicht-Heteroübergang auf einem Träger aus Glas eine elektrisch leitende Unterlage aufzutragen, auf die eine Cadmiumsulfid-Schicht aufgedampft wird, auf welcher dann chemisch eine Kupfersulfid-Schicht erzeugt wird. Auf die Kupfersulfid-Schicht des vorgefertigten Unterteils wird anschließend ein Gitter aufgelegt, wonach die Solarzelle mit einem Deckglas abgedeckt wird, das auf der dem Gitter zugewandten Seite mit einem Heißsiegelkleber versehen ist, mit welchem die Solarzelle versiegelt wird. Das dabei verwendete Gitter ist ein gesondertes Bauteil, das in dieser Form gehandhabt werden muß. Dies bedeutet eine erhebliche praktische Schwierigkeit, da an dem sehr feinen Gitter sich geringfügige Deformationen oder Beschädigungen kaum vermeiden lassen. Diese Beschädigungen oder Deformationen führen zu einer verschlechterten Kontaktgabe und damit zu einer Verminderung des möglichen Wirkungsgrades, insbesondere weil dann das Gitter häufig nur pumktförmig an der Kupfersulfid-Schicht anliegt, so daß die Zahl der Kontaktstellen eingeschränkt wurde.

Es ist auch bekannt (US—PS 3 472 690), ein als Kontaktelement dienendes Gitter für eine Solarzelle dadurch herzustellen, daß es aus einer Metallfolie herausgeätzt wird. Ein derartiges, als unabhängiges Bauteil hergestelltes Gitter kann die im vorstehenden geschilderten Schwierigkeiten bei der Herstellung einer Solarzelle nicht beseitigen.

Der Erfindung liegt die Aufgabe zugrunde, das Verfahren zum Herstellen von Cadmiumsulfid-Solarzellen der eingangs genannten Art weiter zu verbessern, um einen günstigen Wirkungsgrad zu erhalten und gleichzeitig eine in sich geschlossene, verkapselte Zelle herzustellen. Diese Aufgabe wird dadurch gelöst, daß der vorgefertigte Unterteil mit einem vorgefertigten Oberteil heißversiegelt und verpreßt wird, der aus dem Deckglas, dem Heißsiegelkleber und dem Gitter besteht, das in Form einer Folie mit Hilfe des Heißsiegelklebers auf das Deckglas aufgesiegelt wird, wonach vor dem Heißversiegeln und Verpressen des Oberteils und des Unterteils aus der Folie das Gitter herausgeätzt wird.

Der bei dieser Ausbildung verwendete Heißsiegelkleber hat mehrere Funktionen. Zunächst hat er die Funktion, die Kupferfolie an dem Oberteil zu halten und anschließend die Verbindung zu dem Unterteil herzustellen, wobei gleichzeitig eine verkapselte Zelle erhalten wird. Dabei ergibt sich der Vorteil, daß das Gitter aus der Folie herausgeätzt wird, während es von dem Oberteil gehalten ist, so daß die Gefahr von Verformungen oder Beschädigungen weiter verringert wird, so daß mit größerer Sicherheit der mögliche Wirkungsgrad erhalten wird.

In weiterer Ausgestaltung der Erfindung wird vorgesehen, daß das Unterteil eine Glasplatte enthält, auf der vorzugsweise unter Verwendung eines Haftvermittlers eine Unterlage aus Silber oder Zink aufgebracht wird, auf die die Cadmiumsulfid-Schicht aufgedampft wird. Die Verwendung einer Glasplatte in dem Unterteil hat den Vorteil, daß nicht nur die mechanische Festigkeit erhöht wird, sondern daß auch gleichmäßige Wärmeausdehnungen der gesamten Zelle gewährleistet sind, so daß ein Zerstören oder Beschädigen durch Wärmespannungen nicht zu erwarten ist, auch wenn die insbesondere für die terrestrische Anwendung bestimmte Solarzelle in Gebieten aufgestellt wird, in denen beispielsweise sehr große Unterschiede zwischen den Tages- und Nachttemperaturen auftreten.

In weiterer vorteilhafter Ausgestaltung wird vorgesehen, daß der Heißsiegelkleber flüssig aufgetragen und anschließend im Vakuum und gegebenenfalls danach in Atmosphäre getrocknet wird. Durch das erste Trocknen unter Vakuum wird unter Abführen aller eventuell die elektrischen Eigenschaften der Solarzelle störenden Gase und Dämpfe eine Klebeschicht erzeugt, die anschließend ein Heißsiegelkleben ermöglicht und deren Dicke etwas stärker als die Dicke des Gitters ist. Die gegebenenfalls durchzuführende anschließende Trocknung unter atmosphärischen Bedingungen führt zu einer in einigen Fällen zweckmäßigen Oxidation der Heißsiegelklebeschicht.

In zweckmäßiger Ausgestaltung wird weiter vorgesehen, daß vor dem Zusammenfügen von Oberteil und Unterteil auf das Gitter zum Erzielen eines sperrschichtfreien Kontakts eine dünne Goldschicht galvanisch aufgetragen wird.

In weiterer Ausgestaltung der Erfindung wird eine Solarzelle gemäß dem erfindungsgemäßen Verfahren hergestellt, bei welcher das Deckglas mit dem Gitter und die Grundplatte mit der Unterlage derart seitlich zueinander versetzt sind, daß auf der einen Seite ein von der Unterlage und auf der anderen Seite ein von dem Gitter gebildeter Kontakt freiliegen. Eine derartige Solarzelle ist sehr einfach mit weiteren Solarzellen zu verschalten, da die notwendigen Kontakte geschaffen und frei zugänglich sind.

In weiterer vorteilhafter Ausgestalltung der Erfindung ist als Oberteil ein großflächiges Deckglas mit mehreren in einer Reihe angeordneten elektrisch leitenden Gittern vorgesehen, denen jeweils ein Unterteil zugeordnet ist, die derart versetzt zu den Gittern angeordnet sind, daß die Unterlagen einseitig mit dem dem benachbarten Unterteil zugeordneten Gitter in Kontakt stehen und daß an der einen Seite des Deckglases ein Rand des äußeren Gitters als Kontakt freiliegt, während auf der anderen Seite ein Rand der Unterlage des äußeren Unterteils als Kontakt freiliegt. Dadurch läßt sich in einfacher Weise eine fertig verschaltete Solarbatterie schaffen, bei der als Tragelement für mehrere Solarzellen ein einteiliges Deckglas dient. In weiterer Ausgestaltung der Erfindung kann vorgesehen werden, daß ein großflächiges Deckglas mit mehreren Reihen von Gittern und entsprechend mit mehreren Reihen von Unterteilen versehen ist. Damit wird eine sehr rationelle Fertigung erhalten, wobei das etwas einfache aufgebaute Oberteil eine größere Fläche einnimmt, während die Unterteile als einzeln hergestellte Elemente ausgeführt sind, die eine für die Aufbringung der Cadmiumsulfid-Schicht günstige Größe besitzen.

Weitere Merkmale und Vorteile der Erfindung ergeben sich aus der nachfolgenden Beschreibung der in der Zeichnung dargestellten Ausführungsformen.

Fig. 1 zeigt eine schematische Darstellung einer nach dem erfindungsgemäßen Verfahren hergestellten erfindungsgemäßen Solarzelle, bei welcher Unterteil und Oberteil noch gegetrennt sind,

Fig 2 eine Seitenansicht einer aus mehreren Zellen und einem einteiligen Deckglas gebildeten Solarbatterie,

Fig. 3 eine Ansicht der Solarbatterie der Fig. 2 in Richtung des Pfeiles III und

Fig. 4 eine schematische Darstellung einer Einrichtung zum Aufdampfen einer Cadmiumsulfid-Schicht.

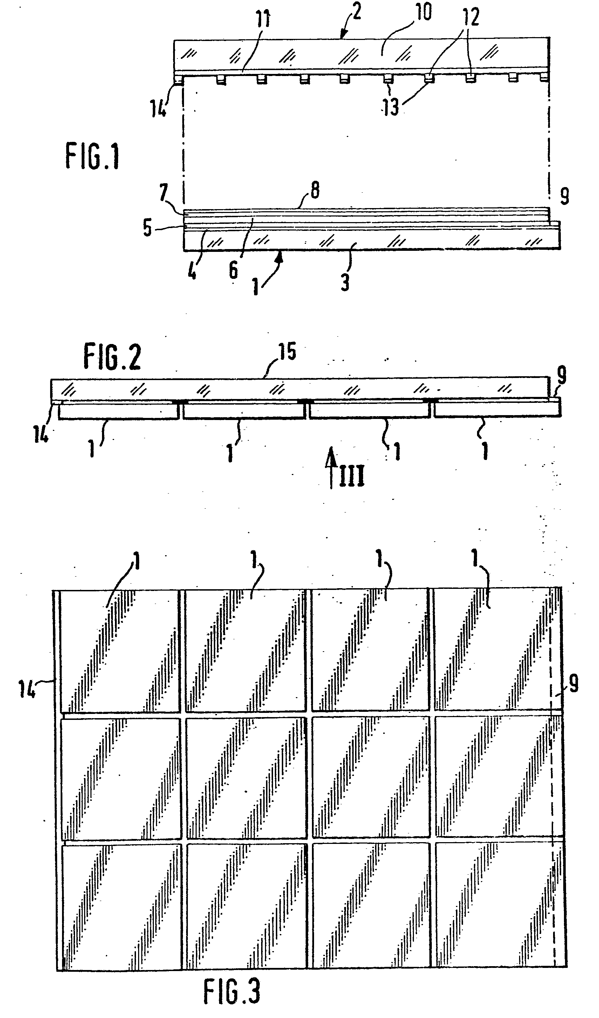

Die in Fig. 1 dargestellte Solarzelle besitzt einen vorgefertigten Unterteil 1 und einen vorgefertigten Oberteil 2, die in einem anschließenden Arbeitsgang zu einer in sich gekapselten Zelle zusammengefügt werden.

Der Unterteil 1 besitzt eine Grundplatte 3, die vorzugsweise aus einem Substratglas besteht. Dieses Glas wird in einem Lösungsmittel mit Ultraschall gereinigt, bevor eine Haftvermittlungsschicht 4 einseitig aufgetragen wird, für die bevorzugt aufgedampftes Chrom (Cr) verwendet wird. Auf diesen Haftvermittler wird eine Schicht 5 aus Silber (Ag) ebenfalls durch Aufdampfen aufgetragen. Dieses Aufdampfen sowohl des Haftvermittlers als auch des Silbers erfolgt bei etwa 400°C, was einerseits zu einem Herauslösen von Wasserdampf und andererseits zu einer guten Auskristallisierung der Silberschicht 5 führt, was für die nachfolgenden Arbeitsgänge von Vorteil ist.

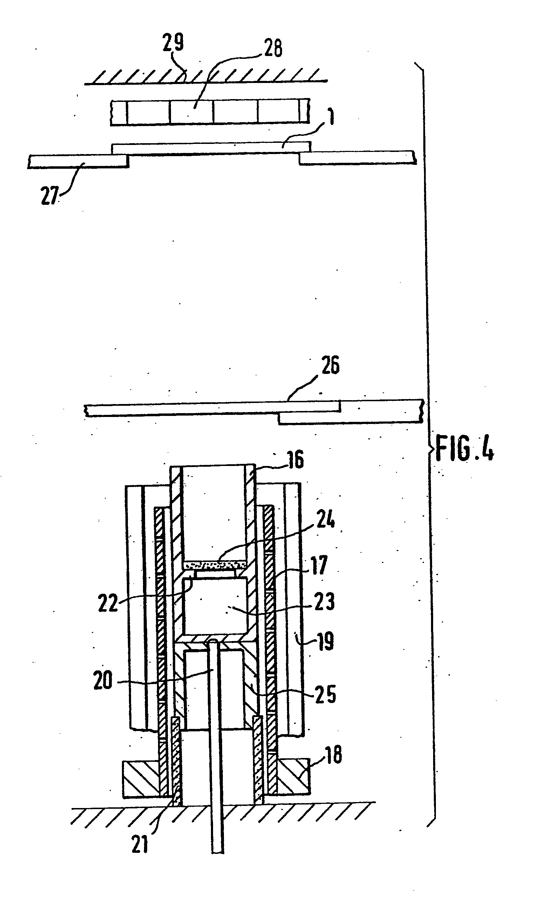

Auf die Schicht 5 aus Silber wird eine Schicht aus Cadmiumsulfid (CdS) von ca. 30 $\mu$ aufgedampft. Dieses Aufdampfen erfolgt in der in Fig. 4 dargestellten Vorrichtung, die später noch erläutert werden wird. Dabei wird der soweit vorgefertigte Unterteil 1 auf einer Temperatur von 200° gehalten.

Als nächstes wird die Cadmiumsulfid-Schicht 6 zur Verringerung von Reflexion und zum Herausätzen von Korngrenzen mit Hilfe einer wässrigen Salzsäure (HCl) aufgerauht. Auf der Cadmiumsulfid-Schicht 6 wird anschließend eine Kupfersulfid $(Cu_2S)$-Schicht 7 erzeugt, was durch eine chemische Reaktion geschieht, indem der Unterteil kurzzeitig für ca 5 bis 10 Sekunden in eine einwertige Kupfer-Ionen-lösung eingetaucht wird. Diese Kupfersulfid-Schicht soll eine Größenordnung von 0,2 $\mu$ Dicke besitzen.

Auf die Kupfersulfid-Schicht 7 wird noch eine Kupfer (Cu)-Schicht 8 aufgedampft, die eine Dicke von 30 bis 100 Å besitzt. Anschließend wird der Unterteil bei ca. 180° unter Atmosphäre aufgeheizt, wodurch ein Auffüllen von Leerstellen durch eindiffundierendes Kupfer in die Kupfersulfid-Schicht und eine Ausbildung einer Kupferoxydulschicht $(Cu_2O)$ ermöglicht werden. Mit diesem Arbeitsgang ist die Herstellung des Unterteils 1 beendet. Wie aus Fig. 1 ersichtlich ist, sind die Schichten 6, 7 und 8 derart aufgetragen, daß in Fig. 1 rechts ein Randstreifen 9 der Unterlage 5 aus Silber freibleibt, die später als Kontakt ausgenutzt werden kann.

Der Oberteil 2 wird ebenfalls getrennt hergestellt. Er enthält ein Deckglas 10, das ebenfalls vor der Weiterbearbeitung mit Ultraschall in einem Lösungsmittel gereinigt wird. Auf dieses Deckglas 10 wird einseitig ein zunächst flüssiger Heißsiegelkleber 11 mit einer Schichtdicke von 120 bis 150 $\mu$ mittels eines Rakel o.dgl. aufgetragen. In der Praxis hat sich hier ein Kleber der Firma Kömmerling, Zweibrücker Landstrasse, 6780 Pirmasens, geeignet, der die Betriebskennzeichnung AK 543 trägt. Das Deckglas 10 und der zunächst flüssig aufgetragene Heißsiegelkleber 11 werden in einem Vakuumofen anschließend bei etwa 100°C für 4 bis 5 Stunden einer Trocknung unterzogen, so daß Dämpfe und Fase aus dem zunächst flüssigen Heißsiegelkleber entweichen können. Es hat sich gezeigt, daß eine anschließende Trocknung bei einer ebenfalls erhöhten Temperatur in der Atmosphäre zu Vorteilen führen kann, wobei wahrscheinlich eine Oxidation des Heißsiegelklebers 11 erfolgt. Bei diesem Trocknungsvorgang reduziert der Heißsiegelkleber seine Dicke auf etwa 25% der ursprünglich 120 bis 150 μ betragenden Auftragsdicke. Mit Hilfe des Heißsiegelklebers 11 wird auf dem Deckglas 10 anschließend eine Kupferfolie von einer Dicke von ca. 35 μ bei etwa 170° bis 180° aufgesiegelt. Aus dieser Kupferfolie wird anschließend das in Fig. 1 dargestellte Gitter 12 herausgeätzt, wobei die bei der Herstellung von Leiterplatten bekannte Technik angewendet wird. Es wird zunächst ein Lackgitter im Siebdruckverfahren aufgetragen, das dem nachher stehenbleibenden Gitter 12 entspricht. Nachdem das Gitter 12 erstellt und der Lack wieder entfernt wurde, wird galvanisch auf das Gitter eine Schicht 13 aus Gold aufgetragen, um einen sperrschichtfreien Kontakt zu ermöglichen. Die Schichtstärke beträgt etwa 100 bis 1000 Å, vorzugsweise 250 Å.

Der nunmehr fertige Oberteil 2 wird mit dem Unterteil 1 in einer Vakuumpresse bei ca. 170° bis 180° verbunden, wobei die Verbindung durch die Schicht 11 des Heißsiegelklebers erhalten wird, die eine Schichtdicke aufweist, die etwas größer als die Dicke des Gitters 12 ist. Das Gitter 12 legt sich mit seiner Goldschicht 13 an die Schicht 8 aus Kupfer an und stellt einen sicheren Kontakt her, während anschließend bei dem Aufheizen das Gitter 12 in die Schicht 11 eindringt, die außerdem noch eine haftende Verbindung zwischen dem Deckglas 10 und der Schicht 8 herstellt. Der Oberteil 2 wird dabei derart versetzt auf dem Unterteil 1 aufgebracht, das in der Zeichnung links, d.h. dem Kontaktstreifen 9 gegenüberliegend ein Streifen 14 des Gitters 12 freiliegt, der ebenfalls als Kontakt dient. Nach diesem Zusammenfügen von Oberteil und Unterteil liegt eine feste in sich geschlossene Zelle vor, die keiner weiteren Behandlung oder Verstäkung bedarf. Gegebenenfalls ist es zweckmäßig, die quer zu den Kontaktstreifen 9 und 14 verlaufenden Ränder abzudichten, was beispielsweise durch Verkleben, Verschweißen oder Verlöten der Deckplatte 10 und der Grundplatte 3 erfolgen kann.

Aus mehreren der in Fig. 1 dargestellten Solarzellen läßt sich eine Solarbatterie zusammensetzen, wobei dann die von den Randstreifen 9 und 14 gebildeten Kontakte der benachbaren Solarzellen miteinander verbunden werden.

Um bei der Erstellung einer Solarbatterie zusätzliche Trägerelemente einzusparen, kann für mehrere Solarzellen ein gemeinsames Deckglas 15 vorgesehen werden, wie dies in Fig. 2 und 3 dargestellt ist. Dabei werden Unterteile 1 verwendet, die entsprechend der vorausgegangenen Beschreibung hergestellt wurden. Diese Unterteile werden zweckmäßig in einer bestimmten Größe hergestellt, in der sie sich wirtschaftlich fertigen lassen. Dagegen bereitet es keine größeren Schwierigkeiten, das gemeinsame Deckglas 15 großflächig herzustellen und mit einer Vielzahl von Gittern 12 in der vorstehend beschriebenen Weise zu versehen. Die Kontakte zwischen den einzelnen Solarzellen werden entsprechend der zur Fig. 1 beschriebenen Weise hergestellt, die in Fig. 2 nur schematisch angedeutet sind. Dabei wird jeweils bei denen in einer Reihe liegenden Solarzellen ein Kontakt des Gitters 12 mit der als elektrisch leitenden Unterlage dienenden Schicht 5 aus Silber hergestellt. Wie in Fig. 3 zu sehen ist, können selbstverständlich mehrere Reihen derartiger Zellen an dem gemeinsamen Deckglas befestigt werden. Die Befestigung erfolgt dann durch die Schicht 11 des Heißsiegelklebers in einem einzigen Arbeitsgang. In der Praxis ist es zweckmäßig, die Stirnseiten zwischen den Kontakten 14 und 9 sowie die Fugen zwischen den einzelnen Zellen abzudichten, was durch Vergießen mit einem Kleber o,dgl. zweckmäßig erfolgen kann. Ebenso ist ein Verlöten oder Verschweißen der Glasplatten möglich.

In Fig. 4 ist schematisch eine Vorrichtung dargestellt, mit welcher eine homogene Schicht Cadmiumsulfid auf ein Unterteil 1 einer Solarzelle aufgedampft werden kann. Hierzu ist ein Graphitofen 16 vorgesehen, der von einer Graphitheizwendel 17 umgeben wird, an die eine Stromzuführung 18 angeschlossen ist. Außen wird die Graphitheizwendel 17 von einem Strahlungsreflektor 19 umschlossen. In den Graphitofen 16 ragt ein die Temperatur für eine Temperaturregelung messendes Thermoelement 20 hinein. Der Graphitofen sitzt auf einem isolierenden Keramikring 21. Der Graphitofen 16 besitzt die Gestalt eines Zylinders, in welchem durch einen Ringbund 22 eine nach oben offene Kammer 23 abgeteilt ist, in die Cadmiumsulfid in pulverförmigem Zustand eingefüllt wird. Die Kammer 23 wird nach oben von einer porösen Quarzfritte 24 verschlossen, die eng in den an den Ringbund 22 nach außen anschließenden zylindrischen Teil eingepaßt ist. Hierzu werden zweckmäßigerweise die Quarzfritte 24 und die Innenfläche des Graphitofens 16 geschliffen. Um ein einwandfreies Bearbeiten zu ermöglichen, ist es zweckmäßig, die Quarzfritte 24 in ein Quarzglasröhrchen einzuschmelzen, das dann außen geschliffen wird. Die Quarzfritte 24 wird in nicht näher dargestellter Weise durch einen oder mehrere Stifte in ihrer Lage gesichert. Die Quarzfritte 24 wird in einem ausreichenden Abstand zu dem Ende des Graphitofens 16 angeordnet, d.h. in etwa auf ein Drittel der Höhe, damit im Bereich der Quarzfritte eine so hohe Temperatur aufrechterhalten wird, daß ein Zudampfen und damit Undurchlässigwerden der Quarzfritte mit Sicherheit vermieden werden kann. An den Graphitofen schließt nach unten ein zylindrischer Ansatz 25 an, der auf dem Keramikring aufsitzt. Dieser Ansatz umhüllt das Thermoelement 20 über eine ausreichende Länge, so daß dadurch sichergestellt wird, daß die von dem Thermoelement 20 gemessene Temperatur möglichst genau der Temperatur der Kammer 23 entspricht.

Über dem Auslaß des Graphitofens 16 ist eine verschiebbare Blende 26 angeordnet, mit der zunächst das ausdampfende Gas von dem Unterteil 1 der Solarzelle eingehalten werden kann. Dieser Unterteil 1 liegt auf einer Auflage 27 auf, die einen Ausschnitt von der Größe freiläßt, die auf dem Unterteil 1 mit Cadmiumsulfid zu bedampfen ist. Auf der gegenüberliegenden Seite ist ein als Graphitmäander ausgebildetes Heizteil 28 vorgesehen, das von einem Strahlungsreflektor 29 abgedeckt wird. Mit diesem Heizteil 28 wird sichergestellt, daß der Unterteil der Solarzelle bei dem Aufdampfen des Cadmiumsulfides eine Temperatur von ca. 200°C einhält.

## Patentansprüche

1. Verfahren zum Herstellen von Solarzellen mit p-n-Dünnschicht-Heteroübergang aus einer auf einem Träger aufgebrachten elektrisch leitenden Unterlage, einer darauf aufgedampften Cadmiumsulfid-schicht und einer darauf chemisch erzeugten Kupfersulfid-Schicht, auf die ein elektrisch leitendes Gitter aufgelegt wird, das mit einem Deckglas, das auf der dem Gitter zugewandten Seite mit einem Heißsiegelkleber versehen wird, abgedeckt, heißversiegelt und verpreßt wird, wobei der Träger mit der Unterlage, mit der Cadmiumsulfid-Schicht und mit der Kupfersulfid-Schicht als ein vorgefertigter Unterteil hergestellt wird, dadurch gekennzeichnet, daß der vorgefertigte Unterteil mit einem vorgefertigten Oberteil heißversiegelt und verpreßt wird, der aus dem Deckglas, dem Heißsiegelkleber und dem Gitter besteht, das in Form einer Folie mit Hilfe des Heißsiegelklebers auf das Deckglas aufgesiegelt wird, wonach vor dem Heißversiegeln und Verpressen des Oberteils und des Unterteils aus der Folie das Gitter herausgeätzt wird.

2. Verfahren nach Anspruch 1, dadurch gekennzeichnet, daß der Unterteil (1) eine Glasplatte (3) enthält, auf der vorzugsweise unter Verwendung eines Haftvermittlers (4) eine Unterlage (5) aus Silber oder Zink bei etwa 400° C aufgedampft wird, auf die die Cadmiumsulfid-Schicht (6) aufgedampft wird.

3. Verfahren nach Anspruch 1, dadurch gekennzeichnet, daß der Heißsiegelkleber (11) flüssig aufgetragen und anschließend in Vakuum und gegebenenfalls danach in Atmosphäre getrocknet wird.

4. Verfahren nach Anspruch 1 oder 3, dadurch gekennzeichnet, daß vor dem Zusammenfügen von Oberteil (2) und Unterteil (1) auf das Gitter (12) zum Erzielen eines sperrschichtfreien Kontakts eine dünne Goldschicht (13) galvanisch aufgetragen wird.

5. Solarzelle hergestellt gemäß dem Verfahren nach einem der Ansprüche 1 bis 4, dadurch gekennzeichnet, daß das Deckglas (10) mit dem Gitter (12) und die Grundplatte (3) mit der Unterlage (5) derart seitlich zueinander versetzt sind, daß auf der einen Seite ein von der Unterlage (5) und auf der anderen Seite ein von dem Gitter (12) gebildeter Kontakt (9, 14) freiliegen.

6. Solarzelle nach Anspruch 5, dadurch gekennzeichnet, daß als Oberteil ein großflächiges Deckglas (15) mit mehreren in einer Reihe angeordneten elektrisch leitenden Gittern vorgesehen ist, denen jeweils ein Unterteil (1) zugeordnet ist, die derart versetzt zu den Gittern angeordnet sind, daß die Unterlagen (5) einseitig mit dem dem benachbarten Unterteil zugeordneten Gitter in Kontakt stehen und daß an der einen Seite des Deckglases ein Rand des äußeren Gitters als Kontakt freiliegt, während auf der anderen Seite ein Rand der Unterlage (5) des äußeren Unterteils (1) als Kontakt freiliegt.

7. Solarzelle nach Anspruch 6, dadurch gekennzeichnet, daß ein großflächiges Deckglas (15) mit mehreren Reihen von Gittern und entsprechend mit mehreren Reihen von Unterteilen (1) versehen ist.

8. Solarzelle nach wenigstens einem der Ansprüche 5 bis 7, dadurch gekennzeichnet, daß die nicht im Bereich der freiliegenden Kontakte (9, 14) befindlichen Ränder des Deckglases (10, 15) und der Grundplatte (3) dichtend miteinander verbunden sind.

## Revendications

1. Procédé pour la réalisation de cellules solaires avec une hétéro-transition en couche mince pn constituée d'une sous-couche électriqement conductrice rapportée sur un support, d'une couche de sulfure de cadmium vaporisée par dessus, et d'une couche de sulfure de cuivre obtenue chimiquement sur la couche précédente, et sur laquelle est posée une grille électriquement conductrice, qui est recouverte d'un verre muni sur sa face tournée vers la grille d'une colle pour scellement à chaud, et qui est scellée à chaud et pressée, le support avec la sous-couche et avec la couche de sulfure de cadmium et la couche de sulfure de cuivre étant réalisé en tant que partie inférieure préfabriquée, procédé caractérisé en ce que la partie inférieure préfabriquée est scellée à chaud et pressée avec une partie supérieure préfabriquée, qui est constituée du verre de recouvrement, de la colle pour scellement à chaud et de la grille, laquelle est appliquée sous la forme d'une feuille, à l'aide de a colle pour scellement à chaud, sur le verre de recouvrement, après quoi, avant le scellement à chaud et le pressage de la partie supérieure et de la partie inférieure, la grille est formée de la feuille par attaque chimique.

2. Procédé selon la revendication 1, caractérisé en ce que la partie inférieure (1) contient une plaquette de verre (3), sur laquelle est vaporisée à environ 400°C, de préférence avec utilisation d'un intermédiaire d'adhérence (4), une sous-couche (5) d'argent ou de zinc, sur laquelle est vaporisée la couche (6) de sulfure de cadmium.

3. Procédé selon la revendication 1, caractérisé en ce que la colle pour scellement à chaud (11) est appliquée sous forme liquide et est ensuite séchée sous vide puis éventuellement dans l'atmosphère.

4. Procédé selon la revendication 1 ou 2, caractérisé en ce que, avant l'assemblage de la partie supérieure (2) et de la partie inférieure (1), une couche mince d'or (13) est appliquée galvaniquement sur la grille (12) pour obtenir un contact exempt de couche de blocage.

5. Cellule solaire réalisée conformément au procédé selon l'une des revendications 1 à 4, caractérisée en ce que comme partie supérieure, (10) avec la grille (12), et la plaque de base (3) avec la sous-couche (5), sont décalés latéralement l'un par rapport à l'autre de façon telle, que sur l'un des côtés est dégagé un contact (9) constitué par la sous-couche (5) tandis que sur l'autre côté est dégagé un contact (14) constitué par la grille (12).

6. Cellule solaire selon la revendication 5, caractérisé en ce que comme partie supérieure, il est prévu un verre de recouvrement (15) de grande surface avec plusieurs grilles électriquement conductrices disposées selon une rangée, et à chacune desquelles est associée une partie inférieure (1), cette partie inférieure étant décalée par rapport aux grilles de façon telle que les sous-couches (5) sont d'un côté en contact avec la grille associée à la partie inférieure voisine, et que sur l'un des côtés du verre de recouvrement, un bord de la grille externe est dégagé comme contact, tandis que sur l'autre côté un bord de la sous-couche (5) de la partie inférieure externe (1) est dégagé comme contact.

7. Cellule solaire selon la revendication 6, caractérisée en ce qu'il est prévu un verre de recouvrement (15) de grande surface avec plusieurs rangées de grilles et, de façon correspondante, avec plusieurs rangées de parties inférieures (1).

8. Cellule solaire selon au moins l'une des revendications 5 à 7, caractérisée en ce que les bords du verre de recouvrement (10, 15) ne se trouvant pas dans la zone des contacts dégagés (9, 14), et la plaque de base (3), sont reliés ensemble de façon étanche.

## Claims

1. A method for producing solar cells with a thin film PN heterojunction using an electrically conductive support applied upon a base, a cadmium sulfide layer vapor deposited thereon and a cuprous sulfide layer chemically produced on the said cadmium sulfide layer, upon said cuprous sulfide layer an electrically conductive grid being superimposed, said grid being covered heat-sealed and pressed with a cover glass member provided on the side facing the grid with a heat-sealing adhesive, whereby the base with the support, the cadmium sulfide layer and the cuprous sulfide layer being initially produced to form a prefabricated lower part, characterized in that said pre-fabricated lower part being heat-sealed and compressed with a pre-fabricated upper part consisting of the cover glass member, the heat-sealing adhesive and the grid, said grid being heat-sealed as a film to the cover glass member by means of the heat-sealing adhesive and then etched out of said film before the upper part and the lower part are heat-sealed and compressed.

2. A method in accordance with claim 1, characterized in that the lower part (1) comprises a glass plate (3) upon the said glass plate (3), a support (5) consisting of silver or zinc is vapor deposited at about 400°C, using preferably an adhesion promoter (4), upon said support (5) the cadmium sulfide layer (6) is vapor deposited.

3. A method in accordance with claim 1, characterized in that the heat-sealing adhesive (11) is applied in the liquid state and subsequently dried in a vacuum, which drying process may be followed by drying in air.

4. A method in accordance with claim 1 or 3, characterized in that a thin gold layer (13) is formed on the grid (12) by electrodeposition, prior to joining the upper part (2) and lower part (1), to produce a contact which is free of insulation.

5. A solar cell produced by the process according to any of claims 1 to 4, characterized in that the cover glass member (10) with the grid (12) and the base plate (3) with the support (5) are shifted laterally relative to each other so as to expose contacts (9, 14) formed on the one side by the support (5) and on the other side by the grid (12).

6. A solar cell in accordance with claim 5, characterized in that the upper part consists of a large-area cover glass member (15) with a plurality of electrically conductive grids provided thereon in one row, each of said grids is associated with one lower part (1) shifted relative to the grid in such a way that the supports (5) have one side in contact with the grid associated with the neighbouring lower part and that on one side of the cover glass an edge strip of the outer grid is exposed to serve as a contact while on the opposite side an edge strip of the support (5) of the outer lower part (1) is exposed to serve as a contact.

7. A solar cell in accordance with claim 6, characterized in that a large-area cover glass (15) is provided with several rows of grids and a corresponding number of rows of lower parts (1).

8. A solar cell in accordance with at least one of claims 5 to 7, characterized in that the edges of the cover glass (10, 15) and of the base plate (3) outside the area of the exposed contacts are sealed together.

**FIG.1**

**FIG.2**

**FIG.3**

0 000 715

FIG.4

2